# FASCICULE DE BREVET EUROPEEN

(11) **EP 0 584 349 B1**
(45) Date de publication et mention de la délivrance du brevet: **02.01.2002**
(21) Numéro de dépôt: 93918735.7
(22) Date de dépôt: 10.03.1993
(51) Int. Cl.: H01L 25/065, H01L 25/10, H01L 21/60

(54) **PROCEDE D'INTERCONNEXION EN TROIS DIMENSIONS DE BOITIERS DE COMPOSANTS ELECTRONIQUES, ET DISPOSITIF OBTENU PAR CE PROCEDE**
HERSTELLUNGSVERFAHREN UND VORRICHTUNG EINER DREIDIMENSIONALEN VERDRAHTUNG VON GEHAEUSEN FUER ELEKTRONISCHE KOMPONENTEN
PROCESS AND DEVICE FOR THREE-DIMENSIONAL INTERCONNECTION OF HOUSINGS FOR ELECTRONIC COMPONENTS

(30) Priorité: 13.03.1992 FR 9203009
(43) Date de publication de la demande: 02.03.1994
(73) Titulaire: Thales, 75008 Paris (FR)
(72) Inventeur: VAL, Christian, F-92402 Courbevoie Cédex (FR)
(74) Mandataire: Benoit, Monique
(86) Numéro de dépôt international: FR9300239
(87) Numéro de publication internationale: WO9318549

(56) Documents cités:
- EP-A- 0 354 708
- EP-A- 0 490 739
- EP-A- 0 516 096
- WO-A-88/08203
- WO-A-92/03035
- US-A- 5 019 946
- US-A- 5 043 794
- IEEE TRANSACTIONS ON COMPONENTS,HYBRIDS,AND MANUFACTURING TECHNOLOGY vol. 13, no. 4, Décembre 1990, NEW YORK US pages 814 - 821 C.VAL ET AL. '3-D Interconnection for Ultra-Dense Multichip Modules'

## Description

La présente invention a pour objet un procédé pour l'interconnexion de boîtiers empilés, ainsi que le dispositif en résultant, chacun des boîtiers encapsulant un composant électronique tel que pastille semi-conductrice contenant par exemple un circuit intégré, ou un circuit électronique ou un capteur ; ces composants seront désignés ci-après indifféremment par les termes composants ou pastilles.

La réalisation des systèmes électroniques actuels, tant civils que militaires, doit tenir compte d'exigences de plus en plus grandes de compacité, du fait du nombre de plus en plus élevé de circuits mis en oeuvre. En ce sens, il a déjà été proposé de réaliser des empilements de circuits intégrés, comme par exemple décrit dans le brevet américain US-A-4.706.166 et dans le document WO-A-8 808 203. Selon cette réalisation, les pastilles elles-mêmes sont disposées sur un circuit imprimé, accolées les unes aux autres perpendiculairement au circuit imprimé; les plots de connexion de chacune des pastilles sont ramenés sur un même côté de la pastille ; ce côté est disposé sur le circuit imprimé et les connexions avec ce dernier y sont réalisées. Toutefois, cet arrangement présente notamment des limitations liées au nombre de plots qu'il est matériellement possible de disposer sur un seul côté d'une pastille semi-conductrice ; en outre, il est onéreux du fait que les pastilles ne sont pas standard (la disposition des plots doit être modifiée) ; enfin, les connexions ainsi réalisées sont peu accessibles et de plus non visibles; or, dans certaines applications, ceci est une nécessité; cet inconvénient en limite l'utilisation.

La présente invention a pour objet d'éviter les limitations précédentes en empilant et en interconnectant non plus des pastilles, mais des boîtiers contenant les composants et en utilisant les faces de l'empilement comme surfaces d'interconnexion.

De la sorte, d'une part sont évités les inconvénients et limitations précédents et, d'autre part, le prix de revient en est diminué: en effet, notamment lorsqu'il s'agit de pastilles semi-conductrices, les pastilles sous boîtier, en plastique généralement, sont disponibles sur le marché à des prix inférieurs à ceux pratiqués pour les pastilles seules, principalement pour des raisons de quantités fabriquées, et leur test est en outre plus aisé donc moins onéreux.

Plus précisément, l'invention a pour objet un procédé d'interconnexion tel que défini par la revendication 1, ainsi qu'un dispositif comportant des boîtiers empilés et interconnectés tel que défini par la revendication 9.

D'autres objets, particularités et résultats de l'invention ressortiront de la description suivante, illustrée par les dessins annexés, qui représentent :
- la figure 1, un mode de réalisation du procédé selon l'invention ;
- les figures 2a et 2b, des exemples de boîtiers susceptibles d'être insérés dans le dispositif selon l'invention ;
- la figure 3, une étape de la fabrication du dispositif selon l'invention ;
- les figures 4a à 4c, différentes variantes d'une étape suivante de la fabrication du dispositif selon l'invention ;
- la figure 5, une vue partielle d'un mode de réalisation du dispositif selon l'invention ;
- les figures 6a et 6b, des détails de réalisation de la figure précédente ;
- la figure 7, un autre mode de réalisation du dispositif selon l'invention ;
- la figure 8, une variante de réalisation du procédé selon l'invention ;
- la figure 9, une étape de la fabrication selon la figure précédente.

Sur ces différentes figures, les mêmes références se rapportent aux mêmes éléments. En outre, pour la clarté des dessins, l'échelle réelle n'a pas été respectée.

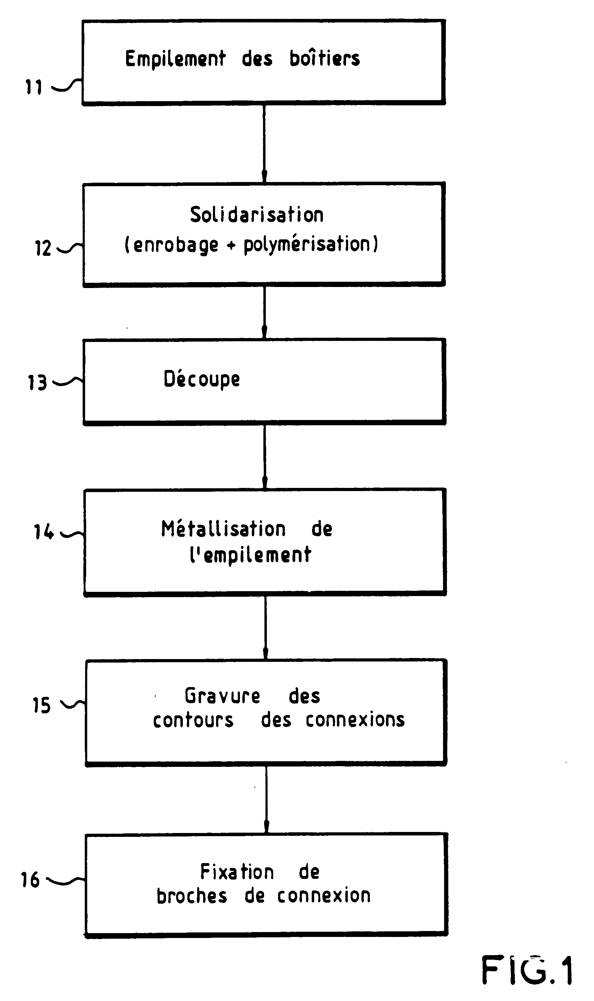

La figure 1 illustre donc un mode de réalisation du procédé selon l'invention.

La première étape du procédé, repérée 11, consiste à empiler des boîtiers, chacun contenant un composant électronique, par exemple une pastille semi-conductrice dans laquelle est réalisé un circuit intégré. Les boîtiers sont chacun en outre munis de broches de connexion.

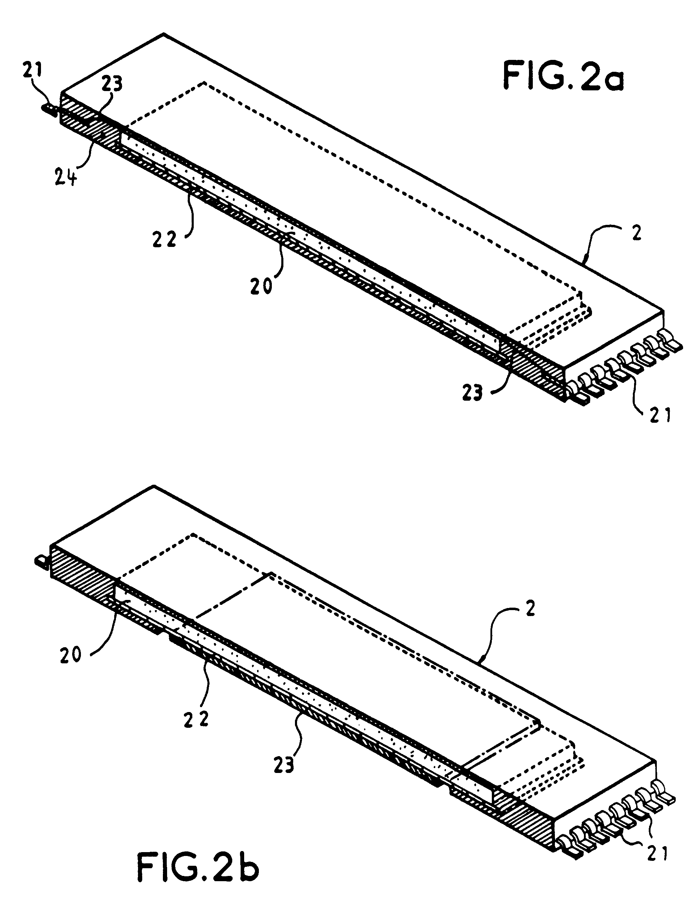

La figure 2a illustre un exemple d'un tel boîtier.

Sur cette figure, on a représenté un boîtier, globalement repéré 2, par exemple rectangulaire ; il comporte des broches de connexion 21 émergeant par exemple sur deux de ses côtés, par exemple les petits côtés. Une coupe a été réalisée dans le boîtier selon sa grande longueur ; on y distingue la pastille 20, disposée en général sur une feuille électriquement conductrice 22, ainsi que deux broches 21 se prolongeant à l'intérieur du boîtier 2 et reliées par des fils conducteurs 23 aux plots de connexion (non représentés) de la pastille 20. Dans une variante de réalisation, la feuille 22 et les brochés 21 sont formées dans une même feuille conductrice, les parties 21 et 22 étant maintenues solidaires par des parties situées à l'extérieur d'un certain périmètre, une découpe ultérieure étant réalisée selon ce périmètre.

Dans le mode de réalisation représenté, les différents éléments précédents sont noyés dans un matériau plastique 24 formant le boîtier, résine époxy par exemple. Le boîtier représenté peut être par exemple du type TSOP (pour Thin Small Outline Package).

La figure 2b représente un autre exemple d'un boîtier susceptible d'être utilisé dans le dispositif selon l'invention.

Sur cette figure, analogue à la figure 2a, on retrouve un boîtier 2 vu en coupe et comportant des broches de connexion 21, ainsi que la pastille semi-conductrice 20 ; sur la figure 2b, la coupe n'étant pas faite au droit d'une broche 21, la partie de celle-ci qui est intérieure au boîtier 2 n'est pas visible. Dans cette variante, le boîtier comporte en outre une plaque 23, réalisée en un matériau bon conducteur de la chaleur et formant drain thermique, cette plaque constituant au moins en partie le fond du boîtier 2.

Dans une autre variante de réalisation, non représentée, un drain thermique peut être réalisé à partir de la feuille 22. A cet effet, celle-ci se prolonge sur un des côtés du boîtier, de préférence sur un côté ne comportant pas de broches.

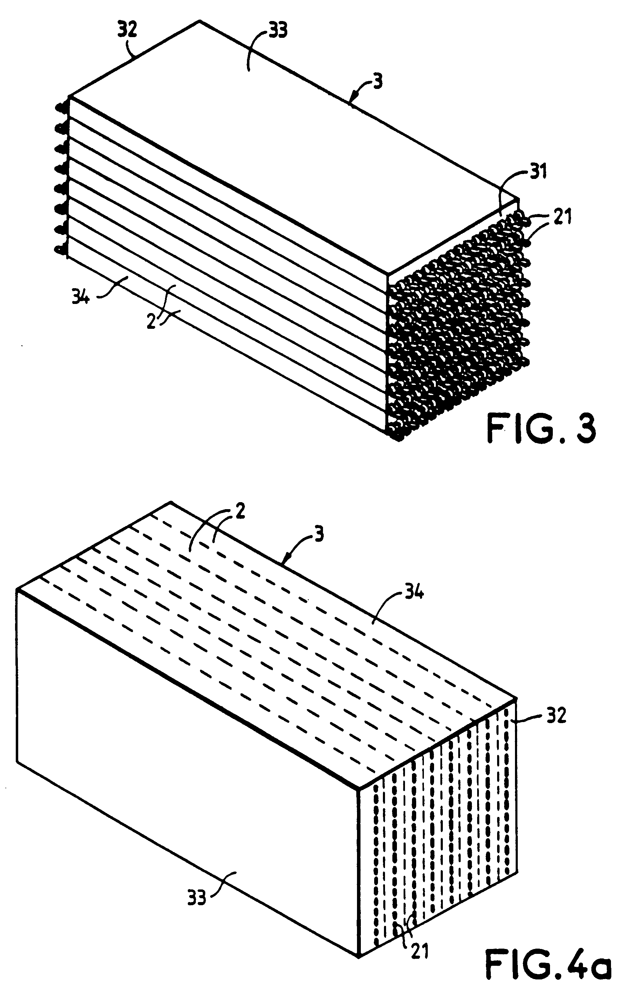

La figure 3 représente, vu en perspective, l'empilement 3 des boîtiers 2 réalisé lors de l'étape 11, les boîtiers étant par exemple tels que représentés figure 2a. On a repéré par 31 et 32 les faces de l'empilement qui comportent les broches 21, par 33 la face supérieure de l'empilement (parallèle aux boîtiers 2) et par 34 l'une des autres faces latérales.

Lors de l'étape suivante (12, figure 1), on procède à la solidarisation des boîtiers empilés par enrobage de l'ensemble par un matériau électriquement isolant, tel qu'une résine polymérisable, époxy par exemple. Dans un mode de réalisation préféré, on choisit le matériau d'enrobage pour qu'il soit thermo-mécaniquement adapté au matériau formant le boîtier, de façon à faciliter la dissipation thermique des pastilles par conduction à travers boîtier et enrobage, et à éviter les ruptures éventuellement dues à des différences trop grandes dans les valeurs des coefficients de dilatation des matériaux.

L'étape suivante (13, figure 1) consiste à découper l'empilement de sorte que les broches 21 des différents boîtiers affleurent les faces de l'empilement, ainsi que, le cas échéant, les drains thermiques.

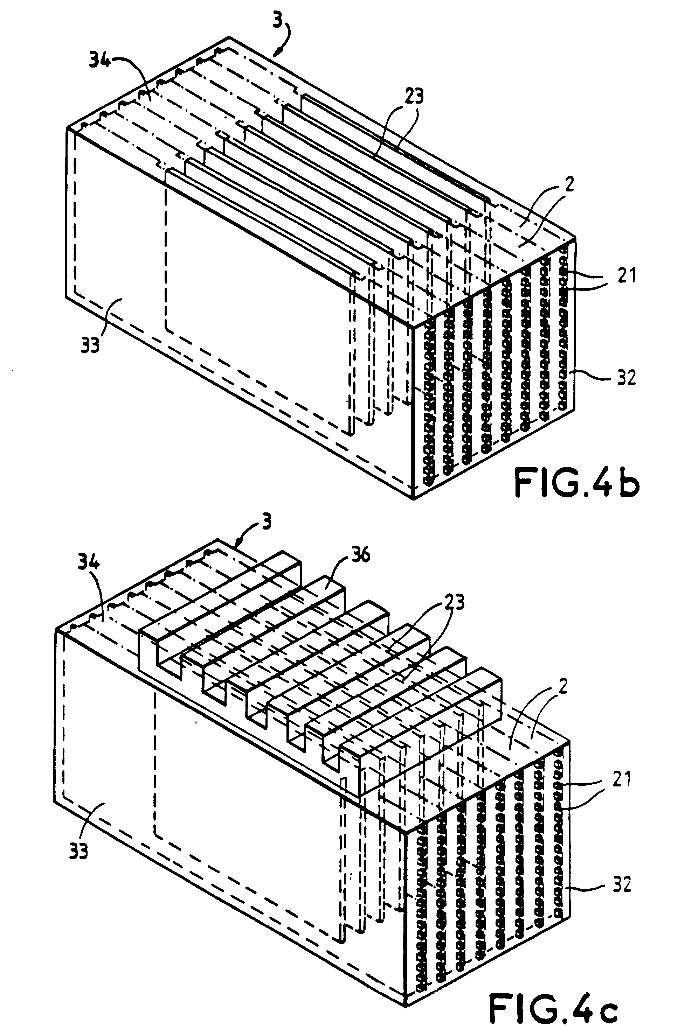

La figure 4a représente le résultat de cette étape 13, dans le cas des boîtiers illustrés sur la figure 2a.

Sur cette figure sont visibles les faces 32, 33 et 34 de l'empilement 3 ; on retrouve les broches 21 maintenant affleurant la face 32 ; les boîtiers 2 ont été représentés en pointillés, n'étant plus visibles du fait du matériau d'enrobage.

La figure 4b est une vue analogue à celle de la figure 4a, mais dans le cas des boîtiers illustrés sur la figure 2b. L'empilement, toujours référencé 3, est formé des boîtiers 2 qui comportent chacun un drain thermique 23. Ces derniers affleurent les faces latérales de l'empilement, c'est-à-dire la face 34 et la face qui lui est opposée, comme les broches 21 des boîtiers affleurent les faces 31 et 32.

La figure 4c est une variante de la figure précédente, où on a disposé un dissipateur thermique 36, par exemple un radiateur à ailettes, sur la face 34 de l'empilement 3 où affleurent les drains thermiques 23. Un dissipateur du même genre peut également être disposé sur la face de l'empilement qui est opposée à la face 34 et où les drains 23 peuvent également affleurer.

La fixation du radiateur 36 peut par exemple s'effectuer par collage, à l'aide d'une colle époxy par exemple, soit directement sur la face de l'empilement, soit après métallisation de celle-ci comme décrit ci-après.

L'étape suivante (14, figure 1) consiste à déposer une (ou plusieurs) couche(s) conductrice(s), métallique(s) par exemple, sur l'ensemble des faces de l'empilement 3 précédemment réalisé.

L'étape suivante (15, figure 1) consiste à réaliser sur les faces de l'empilement 3, à partir de la couche métallique précédente, des connexions reliant les broches 21 entre elles.

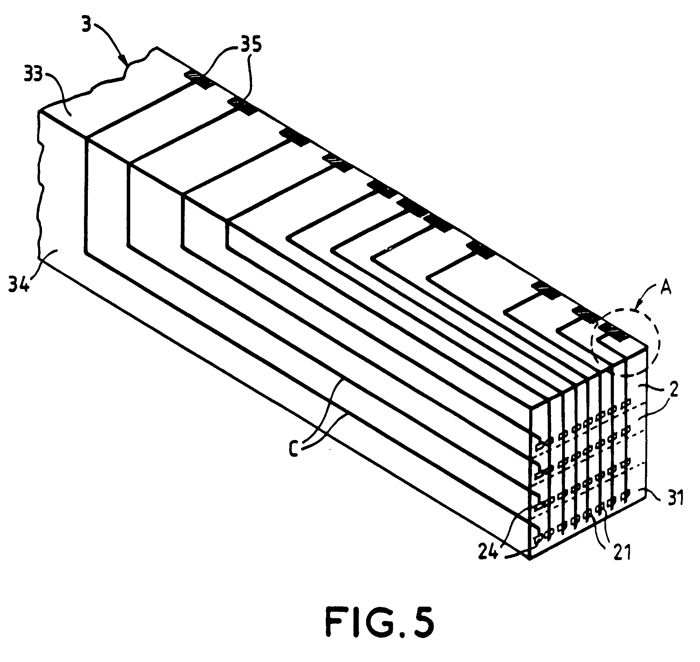

La figure 5 est une vue fractionnaire d'un empilement selon l'invention, sur laquelle sont illustrés des exemples de connexion.

Sur cette figure, on a représenté l'empilement 3 dont les faces 31, 33 et 34 sont visibles. On a représenté également les boîtiers 2 en pointillés et leurs broches de connexion 21, affleurant la face 31. L'empilement 3 comporte sur une ou plusieurs de ses faces, par exemple sur la face 33, des plots 35, dits plots d'empilement, pour sa liaison électrique à des circuits extérieurs. Les broches 21 sont à la fois interconnectées entre elles et, quand nécessaire, reliées aux plots d'empilement 35 à l'aide de connexions C.

A titre d'exemple, on a représenté sur la figure le cas où les boîtiers 2 contiennent des mémoires ; dans ce cas, l'ensemble de leurs broches homologues sont reliées entre elles et à un plot d'empilement 35 sauf une, repérée 24, pour chacun des boîtiers. Cette broche 24, qui correspond à l'entrée de sélection de la mémoire, est reliée pour chaque boîtier individuellement à un plot d'empilement 35 distinct. Bien entendu, si les boîtiers comportent davantage de broches telles que 24, nécessitant une individualisation, on procède de même pour chacune.

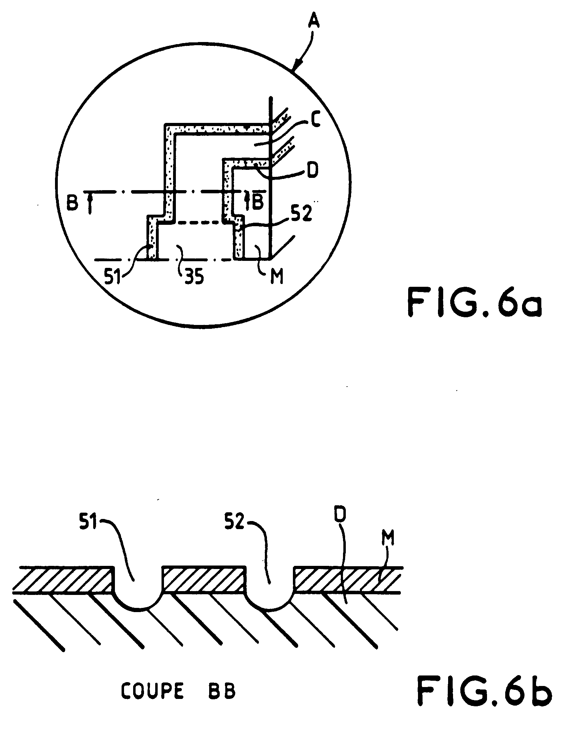

Les figures 6a et 6b illustrent plus en détail un mode de réalisation des connexions C.

La figure 6a représente une vue fractionnaire et agrandie d'un morceau A de l'empilement de la figure 5, où l'on voit une connexion C et un plot d'empilement 35. La figure 6b est une vue en coupe selon un axe BB de la figure 6a.

Chacune des connexions C est formée par deux gravures 51 et 52, réalisées à l'aide d'un laser qui détruit localement la couche conductrice, repérée M, et fait apparaître le matériau isolant de solidarisation de l'empilement, repéré D; ce matériau D a été représenté en pointillés sur la figure 6a pour la clarté du schéma. De la sorte, on réalise l'isolation électrique de la connexion C du reste de la couche M. Les plots d'empilement 35 peuvent être avantageusement réalisés par la même technique de gravure laser comme représenté sur la figure 6a.

Une autre méthode de réalisation des connexions C consiste à réaliser d'abord des rainures dans le matériau d'enrobage de l'empilement 3, au niveau où les broches 21 affleurent, de sorte à dégager l'extrémité de ces dernières, et opérer ces rainures selon le dessin retenu pour les connexions C; ces rainures peuvent être réalisées par laser; puis on dépose une couche électriquement conductrice (métal par exemple) sur l'ensemble de l'empilement, faces et rainures ; enfin, on enlève la couche conductrice des surfaces planes de l'empilement (par polissage ou par laser par exemple), de sorte à ne la laisser subsister que dans les rainures où elle réalise les connexions recherchées.

D'autres méthodes de réalisation des connexions C sont bien entendu possibles, comme la photolithogravure par exemple.

Il est à noter que les connexions C et les plots d'empilement 35 peuvent être disposés sur des faces quelconques de l'empilement ou même la totalité des faces, le choix se faisant en fonction de l'application. Dans le cas où les boîtiers 2 comportent un drain thermique 23 comme représenté par exemple sur la figure 2b, celui-ci peut être réalisé en un matériau électriquement isolant (nitrure d'aluminium, carbure de silicium, par exemple) si on souhaite disposer des broches 21 et/ou former des connexions C sur les faces où affleurent les drains 23.

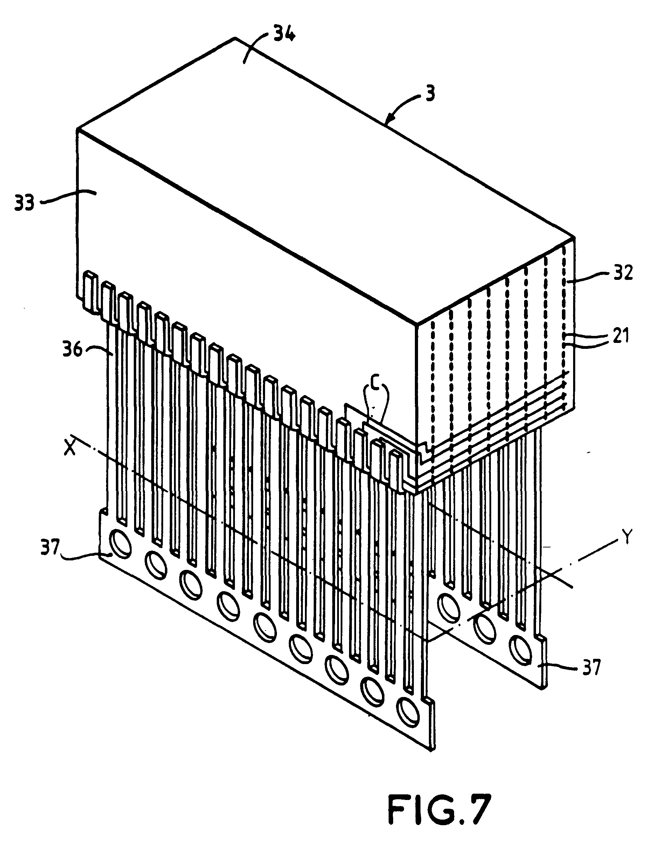

La dernière étape du procédé représenté figure 1, repérée 16, consiste en la fixation sur l'empilement de broches de connexion, comme illustré sur la figure 7.

Sur cette figure, on retrouve l'empilement 3 dont les faces 32, 33 et 34 sont visibles, ainsi que les broches 21 des boîtiers, affleurant la face 32. A titre d'exemple, on a représenté certaines des connexions C reliant des broches 21 aux plots d'empilement ; toutefois, ceux-ci ne sont pas ici visibles parce que recouverts par l'extrémité de broches 36 de deux grilles 37 par exemple, les broches 36 étant destinées à former les broches de connexion de l'empilement, après découpe selon un plan XY, ainsi qu'il est connu dans le domaine de l'encapsulation des composants.

Cette dernière étape est optionnelle. En effet, un empilement 3 n'est pas nécessairement muni de broches de connexion : il peut être monté "à plat", c'est-à-dire soit par soudure directe sur ses plots d'empilement, sur un circuit imprimé, les boîtiers étant alors disposés parallèlement ou perpendiculairement au circuit, ou sur un autre empilement, soit par l'intermédiaire de grilles adaptées.

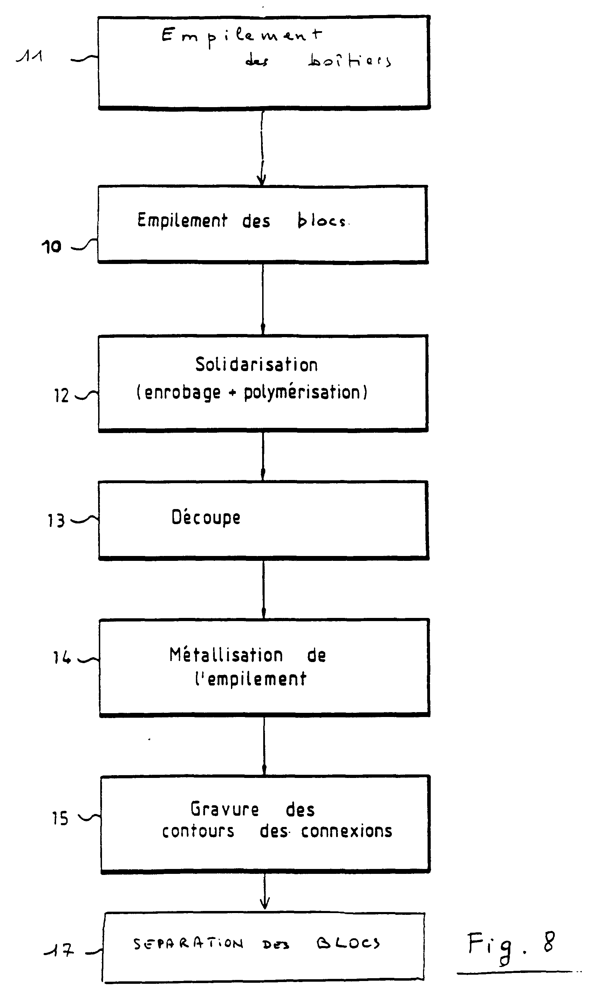

Dans une variante de réalisation, on procède à un empilement de blocs, eux-mêmes formés de boîtiers empilés, pour augmenter le nombre de boîtiers traités simultanément et, par suite, diminuer le coût. Cette variante est représentée figure 8.

La première étape, 11, consiste comme précédemment à empiler les boîtiers pour former un bloc.

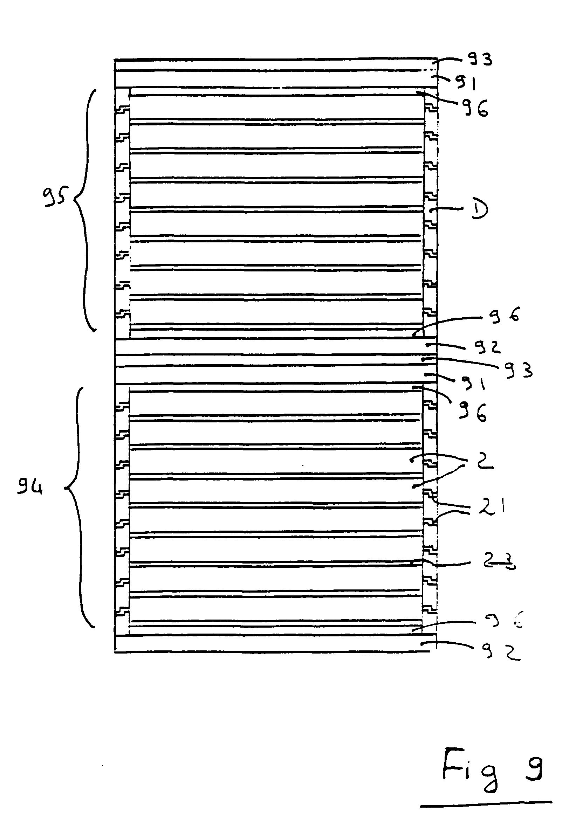

La deuxième étape, repérée 10, consiste à empiler un certain nombre de blocs ainsi obtenus, en ajoutant certaines couches intercalaires, comme illustré sur la figure 9. A titre d'exemple, on peut empiler ainsi une vingtaine de blocs.

Sur la figure 9, on a représenté par exemple deux blocs, 94 et 95, vus en coupe, constitués chacun de par exemple huit boîtiers 2 et comportant par exemple chacun un drain thermique 23, s'étendant ou non sur toute la longueur du boîtier. Entre les deux blocs 94 et 95, on dispose une cale 93 destinée à permettre ultérieurement la séparation des blocs ; elle est à cet effet de dimensions supérieures à celles des boîtiers ; elle est par exemple en silicone. Dans la variante représentée, on a en outre disposé deux substrats du type circuit imprimé de part et d'autre de chaque bloc, repérés 91 et 92, permettant de faciliter le routage des connexions. Les circuits imprimés sont par exemple collés (couche 96) sur les boîtiers 2 et rendus solidaires entre eux par l'intercalaire 93. Les circuits 91 et 92 peuvent également être remplacés par des cales isolantes, époxy par exemple.

L'ensemble des blocs est ensuite solidarisé par un matériau isolant D, comme l'étaient précédemment les boîtiers (étape 12), puis découpé ou meulé (étape 13). La figure 9 représente les deux blocs à l'issue de l'étape 13.

Les étapes 14 et 15 précédentes sont réalisées sur l'empilage des blocs puis, dans une étape 17, les blocs sont séparés. On a ainsi réalisé un certain nombre d'opérations collectivement, sur un grand nombre de blocs, notamment la réalisation de la connectique sur les faces latérales des blocs. On peut bien entendu procéder ensuite à une opération de fixation de broches de connexion.

Il a été ainsi décrit un dispositif d'interconnexion en trois dimensions de boîtiers contenant des composants électroniques qui présente de nombreux avantages :
- permettre une densité de composants élevée : en effet, les boîtiers sont ici empilés et, ce, sans espacement entre les boîtiers ;
- être utilisable avec des boîtiers présentant des broches de connexion sur un nombre quelconque de côtés : en effet, l'invention ne nécessite pas qu'une ou deux des faces latérales soient libres de broches :

- être applicable à l'empilement d'un nombre quelconque de boîtiers ;
- permettre à la fois une bonne adaptation et une bonne dissipation thermiques ;
- présenter un coût de production bas, notamment parce qu'il se prête à l'utilisation des boîtiers à leur sortie du moule, lorsqu'ils sont encore reliés en barrettes : les barrettes sont alors empilées comme décrit ci-dessus pour les boîtiers et plusieurs empilements peuvent être ainsi réalisés collectivement.

On a illustré sur les figures l'empilement de boîtiers ayant sensiblement la même taille mais ceci n'est pas nécessaire : lorsque les boîtiers sont de dimensions différentes, l'invention s'applique sous réserve de mettre tous les boîtiers aux cotes du plus grand, à l'aide pour chacun d'un support du type circuit imprimé sur lequel le boîtier est connecté, ce circuit imprimé pouvant être multicouche, facilitant ainsi le routage des connections.

## Revendications

1. Procédé d'interconnexion en trois dimensions de boîtiers fermés contenant au moins un composant électronique et munis de broches de connexion, **caractérisé par le fait qu'**il comporte les étapes suivantes :
- empilement (11) des boîtiers qui conduit à la formation de blocs lesdits blocs étant formés desdits boîtiers empilés ;
- solidarisation par enrobage (12) de chacun de cesdits blocs à l'aide d'un matériau électriquement isolant ;
- découpe (13) de l'empilement au niveau des broches des boîtiers, de sorte que ces dernières affleurent les faces de l'empilement ;
- formation (14, 15) de connexions électriques entre les broches sur les faces de l'empilement.

2. Procédé selon la revendication 1, **caractérisé par le fait que** le matériau isolant est une résine polymérisable.

3. Procédé selon l'une des revendications précédentes, **caractérisé par le fait que** l'étape de formation de connexions électriques se décompose en deux sous-étapes :
- la première sous-étape (14) consistant en un dépôt d'une couche conductrice sur l'ensemble des faces de l'empilement ;
- la deuxième sous-étape (15) consistant en une gravure de la couche conductrice pour former des connexions électriques reliant les broches entre elles.

4. Procédé selon l'une des revendications 1 ou 2, **caractérisé par le fait que** l'étape de formation des connexions se décompose en sous-étapes :
- réalisation de rainures dans l'empilement au niveau où les broches affleurent et selon le dessin souhaité pour les connexions ;
- dépôt d'une couche conductrice sur l'ensemble de l'empilement rainuré ;
- suppression de la couche conductrice sur les surfaces planes de l'empilement, ne la laissant subsister que dans les rainures où elle forme les connexions.

5. Procédé selon l'une des revendications 3 ou 4, **caractérisé par le fait que** les réalisations de gravures ou de rainures sont faites à l'aide d'un laser.

6. Procédé selon l'une des revendications précédentes, **caractérisé par le fait que**, lors de l'étape de formation de connexions électriques, sont formés en outre des plots dits d'empilement, destinés à la connexion de l'empilement avec des circuits extérieurs, et que les connexions électriques relient entre eux au moins certaines des broches et les plots d'empilement.

7. Procédé selon l'une des revendications précédentes, **caractérisé par le fait que** les boîtiers comportent en outre chacun une plaque (22 ; 23) formant drain thermique et que les broches et la plaque sont formées à partir d'une même feuille conductrice.

8. Procédé selon l'une des revendications précédentes, **caractérisé par le fait qu'**il comporte, après l'étape (11) d'empilement des boîtiers, une étape supplémentaire (10) d'empilement des blocs, les étapes ultérieures de solidarisation (12), découpe (13) et formation de connexion (14, 15) étant réalisées sur l'empilement de blocs, et qu'il comporte en outre, après l'étape de formation de connexion, une étape (17) de séparation des blocs.

9. Dispositif comportant des boîtiers fermés (2) empilés et interconnectés, contenant au moins un composant électronique (20) et munis de broches de connexion (21), **caractérisé par le fait qu'**il comporte un matériau isolant (D) enrobant et solidarisant les boîtiers fermés empilés, que les broches des boîtiers affleurent les faces de l'empilement et que des connexions (C) entre les broches sont portées par les faces de l'empilement.

10. Dispositif selon la revendication 9, **caractérisé par le fait que** l'empilement comporte en outre des plots d'empilement (35) formés sur une ou plusieurs de ses faces, ces plots d'empilement étant destinés à la connexion de l'empilement (3) avec des circuits extérieurs, et que les connexions (C) assurent en outre la liaison d'au moins certaines des broches avec les plots d'empilement.

11. Dispositif selon l'une des revendications 9 ou 10, **caractérisé par le fait qu'**il comporte en outre, au niveau de chaque boîtier (2), une plaque (23) formant drain thermique et affleurant les faces de l'empilement.

12. Dispositif selon l'une des revendications 9 à 11, **caractérisé par le fait que** chacun des boîtiers est formé par un matériau isolant (24) dans lequel composant (20) et broches (21) sont noyées.

13. Dispositif selon la revendication 12, **caractérisé par le fait que** le matériau (24) formant le boîtier et le matériau (D) d'enrobage réalisent une adaptation thermo-mécanique.

14. Dispositif selon l'une des revendications 12 ou 13, **caractérisé par le fait que** le matériau (24) formant le boîtier et/ou le matériau d'enrobage sont une résine époxy.

## Patentansprüche

1. Verfahren zum dreidimensionalen Verbinden von geschlossenen Gehäusen, die mindestens ein elektronisches Bauelement enthalten und Anschlußfahnen besitzen, **dadurch gekennzeichnet, daß** es folgende Verfahrensschritte enthält:
- Stapelung (11) von Gehäusen, wodurch sich Blöcke von gestapelten Gehäusen ergeben;
- Solidarisierung (12) mittels Umhüllung jedes der Blöcke durch ein elektrisch isolierendes Material;
- Zerschneiden (13) des Stapels in Höhe der Anschlußfahnen der Gehäuse, sodaß diese Fahnen an den Außenseiten des Stapels zutage treten;
- Bildung (14, 15) von elektrischen Verbindungen zwischen den Anschlußfahnen an den Außenseiten des Stapels.

2. Verfahren nach Anspruch 1, **dadurch gekennzeichnet, daß** das isolierende Material ein polymerisierbares Harz ist.

3. Verfahren nach einem der vorstehenden Ansprüche, **dadurch gekennzeichnet, daß** der Schritt der Bildung von elektrischen Verbindungen aus zwei Teilschritten zusammengesetzt ist, nämlich
- einem ersten Teilschritt (14), der darin besteht, eine leitende Schicht auf alle Außenseiten des Stapels aufzubringen,
- und einem zweiten Teilschritt (15), der darin besteht, die leitende Schicht so zu gravieren, daß elektrische Verbindungen zwischen den Anschlußfahnen entstehen.

4. Verfahren nach einem der Ansprüche 1 und 2, **dadurch gekennzeichnet, daß** der Schritt der Bildung von Verbindungen aus folgenden Teilschritten besteht:
- Bildung von Rinnen am Stapel, und zwar dort, wo die Anschlußfahnen zutage treten und gemäß dem für die Verbindungen gewünschten Verlauf,
- Aufbringen einer leitenden Schicht auf die gesamte und mit Rinnen versehene Außenseite des Stapels,
- Beseitigung der leitenden Schicht auf den ebenen Flächen des Stapels, sodaß diese nur in den Rinnen verbleibt und die Verbindungen bildet.

5. Verfahren nach einem der Ansprüche 3 und 4, **dadurch gekennzeichnet, daß** die Gravuren oder die Rinnen durch einen Laser erzeugt werden.

6. Verfahren nach einem der vorstehenden Ansprüche, **dadurch gekennzeichnet, daß** bei der Bildung von elektrischen Verbindungen zugleich Stapel-Anschlußpunkte hergestellt werden, die zum Anschluß des Stapels an äußere Schaltkreise dienen sollen, und daß die elektrischen Verbindungen mindestens bestimmte der Anschlußfahnen und Stapel-Anschlußpunkte miteinander verbinden.

7. Verfahren nach einem der vorstehenden Ansprüche, **dadurch gekennzeichnet, daß** die Gehäuse außerdem je eine Wärmeabfuhrplatte (22, 23) enthalten und daß die Anschlußfahnen und die Platte ausgehend von einer gemeinsamen leitenden Folie gebildet werden.

8. Verfahren nach einem der vorstehenden Ansprüche, **dadurch gekennzeichnet, daß** es nach dem Verfahrensschritt (11) der Stapelung der Gehäuse einen zusätzlichen Verfahrensschritt (10) der Stapelung von Blöcken enthält, worauf die nachfolgenden Verfahrensschritte der Solidarisierung (12), des Zerschneidens (13) und der Bildung von Verbindungen (14, 15) auf dem Stapel von Blöcken erfolgen, und daß außerdem nach dem Verfahrensschritt der Herstellung von Verbindungen ein Verfahrensschritt (17) der Trennung der Blöcke vorgesehen ist.

9. Vorrichtung mit geschlossenen Gehäusen (2), die gestapelt und miteinander verbunden sind und mindestens ein elektronisches Bauelement (20) sowie Anschlußfahnen (21) aufweisen, **dadurch gekennzeichnet, daß** sie ein isolierendes Material (D) aufweist, das die geschlossenen und gestapelten Gehäuse umhüllt und miteinander solidarisiert, daß die Anschlußfahnen der Gehäuse an den Seiten des Stapels zutage treten und daß die Verbindungen (C) zwischen den Anschlußfahnen an die Außenseiten des Stapels verlegt sind.

10. Vorrichtung nach Anspruch 9, **dadurch gekennzeichnet, daß** der Stapel außerdem Stapel-Anschlußpunkte (35) enthält, die an einer oder mehreren Außenseiten des Stapels ausgebildet sind und für den Anschluß des Stapels (3) an äußere Schaltungen bestimmt sind, und daß die Verbindungen (C) außerdem bestimmte der Anschlußfahnen mit den Stapel-Anschlußpunkten verbinden.

11. Vorrichtung nach einem der Ansprüche 9 und 10, **dadurch gekennzeichnet, daß** sie außerdem in Höhe jedes Gehäuses eine Wärmeabfuhrplatte (23) enthält, die an den Außenseiten des Stapels zutage tritt.

12. Vorrichtung nach einem der Ansprüche 9 bis 11, **dadurch gekennzeichnet, daß** jedes Gehäuse von einem isolierenden Material (24) gebildet wird, in das das Bauelement (20) und die Anschlußfahnen (21) eingebettet sind.

13. Vorrichtung nach Anspruch 12, **dadurch gekennzeichnet, daß** das das Gehäuse bildende Material (24) und das Material (D) zur Umhüllung thermomechanisch aneinander angepaßt sind.

14. Vorrichtung nach einem der Ansprüche 12 und 13, **dadurch gekennzeichnet, daß** das das Gehäuse bildende Material (24) und/oder das Material der Umhüllung ein Epoxyharz ist.

## Claims

1. Method of interconnecting, in three dimensions, closed packages containing at least one electronic component and equipped with connecting pins, **characterized in that** it includes the following stages:
- stacking (11) the packages which leads to the formation of blocks, the said blocks being formed from the said stacked packages;
- integrating, by encapsulating (12) each of these blocks using an electrically insulating material;
- cutting up (13) the stack in the region of the pins of the packages, in such a way that these pins come flush with the faces of the stack;
- forming (14, 15) electrical connections between the pins on the faces of the stack.

2. Method according to Claim 1, **characterized in that** the insulating material is a polymerisable resin.

3. Method according to one of the preceding claims, **characterized in that** the stage of forming electrical connections breaks down into two sub-stages:
- the first sub-stage (14) consisting in depositing a conducting layer on all the faces of the stack;
- the second sub-stage (15) consisting in etching the conducting layer in order to form electrical connections linking the pins together.

4. Method according to one of claims 1 or 2,
**characterized in that** the connection-forming stage breaks down into sub-stages:
- producing grooves in the stack in the region where the pins come flush and according to the layout desired for the connections;
- depositing a conducting layer over the whole of the grooved stack;
- elimination of the conducting layer on the flat surfaces of the stack, leaving it present only in the grooves where it forms the connections.

5. Method according to one of Claims 3 and 4, **characterized in that** the grooves or slots are produced using a laser.

6. Method according to one of the preceding claims, **characterized in that**, during the stage of forming electrical connections, studs known as stack studs are also formed, which are intended for connecting the stack with external circuits, and **in that** the electrical connections link together at least some of the pins and the stack studs.

7. Method according to one of the preceding claims, **characterized in that** the packages each further include a plate (22; 23) forming a heat sink and **in that** the pins and the plate are formed from the same conducting foil.

8. Method according to one of the preceding claims, **characterized in that**, after the stage (11) of stacking the packages, it includes an additional stage (10) of stacking the blocks, the subsequent stages of integrating (12), cutting up (13) and connection-forming (14, 15) being carried out on the stack of blocks, and **in that**, after the connection-forming stage, it further includes a stage (17) of separating the blocks.

9. Device including closed packages (2), stacked and interconnected, containing at least one electronic component (20) and equipped with connecting pins (21), **characterized in that** it includes an insulating material (D) encapsulating and integrating the stacked closed packages, **in that** the pins of the packages come flush with the faces of the stack and **in that** connections (C) between the pins are carried by the faces of the stack.

10. Device according to Claim 9, **characterized in that** the stack further includes stack studs (35) formed on one or more of its faces, these stack studs being intended for connecting the stack (3) with external circuits, and **in that** the connections (C) furthermore provide the link from at least some of the pins to the stack studs.

11. Device according to one of Claims 9 or 10, **characterized in that** it further includes, within each package (2), a plate (23) forming a heat sink and coming flush with the faces of the stack.

12. Device according to one of Claims 9 to 11, **characterized in that** each of the packages is formed from an insulating material (24) in which component (20) and pins (21) are embedded.

13. Device according to Claim 12, **characterized in that** the material (24) forming the package and the encapsulation material (D) achieve a thermo-mechanical matching.

14. Device according to one of Claims 12 and 13, **characterized in that** the material (24) forming the package and/or the encapsulation material are an epoxy resin.
